Europäisches Patentamt

European Patent Office

Office européen des brevets

(11) Veröffentlichungsnummer: **0 187 910**
**B1**

# (12) EUROPÄISCHE PATENTSCHRIFT

(45) Veröffentlichungstag der Patentschrift: **12.09.90**

(21) Anmeldenummer: **85114314.9**

(22) Anmeldetag: **11.11.85**

(51) Int. Cl.⁵: **G 01 R 35/02**, G 01 B 7/02, G 01 D 18/00

(54) **Verfahren zur Kalibrierung eines elektronischen Positionsgebers.**

(30) Priorität: **27.11.84 DE 3443176**

(43) Veröffentlichungstag der Anmeldung:
**23.07.86 Patentblatt 86/30**

(45) Bekanntmachung des Hinweises auf die Patenterteilung:
**12.09.90 Patentblatt 90/37**

(84) Benannte Vertragsstaaten:
**FR GB IT**

(56) Entgegenhaltungen:
**DE-A-3 244 891**

(73) Patentinhaber: **Angewandte Digital Elektronik GmbH**
**Bundesstrasse 25**
**D-2051 Brunstorf (DE)**

(72) Erfinder: **Kreft, Hans-Dietrich**
**Rehkoppel 13**
**D-2055 Aumühle (DE)**
Erfinder: **Mackenthun, Holger**
**Wildschwanbrook 53**
**D-2000 Hamburg 73 (DE)**
Erfinder: **Niznik, Thomas**
**Sibeliusstrasse 1**
**D-2000 Hamburg 150 (DE)**
Erfinder: **Jenning, Michael**
**Oberer Landweg 112**
**D-2050 Hamburg 80 (DE)**
Erfinder: **Baik, Thorsten**
**Hammer Steindamm 115**
**D-2000 Hamburg 26 (DE)**

**Beschreibung**

Die Erfindung betrifft ein Verfahren zur Kalibrierung einer Einrichtung zur berührungslosen Positionsmessung gemäß dem Oberbegriff der Patentansprüche 1 und 2.

Ein derartiges Verfahren ist aus der DE—A—32 44 891 bekannt. Bei dieser Einrichtung werden die jeweiligen Spannungswerte der einzeln abgefragten Sensoren über den gesamten Wirkungsbereich des Magneten der vorgegebenen Magnetposition zugeordnet. Damit erhält jede Magnetposition, gemessen in Längeneinheiten, eine zugeordnete Spannungsverteilung, nachfolgend "Positionsspannungsverteilung" genannt. Mit jeder Positionsverschiebung des Magneten ergibt sich eine neue Positionsspannungsverteilung. Diese Positionsspannungsverteilung ist eindeutig d.h. jedem Magnetpositionswert entspricht genau eine Positionsspannungsverteilung und umgekehrt entspricht einer Positionsspannungsverteilung genau ein Magnetpositionswert. In einem Kalibrierlauf können einzelnen Magnetpositionen die charakteristischen Positionsspannungsverteilungen zugeordnet und abgespeichert werden. Wird in einem anschließenden Meßlauf ein Magnet parallel zu den Sensoren bewegt, können den gemessenen Positionsspannungsverteilungen die im Speicher abgelegten Positionsspannungsverteilungen zugeordnet werden und somit kann auf die unbekannte Position des Magneten geschlossen werden. Ein Magnet, der nach diesem Verfahren mit einem bewegten Teil verbunden ist, kann somit als Positionsindikator für ein bewegtes Teil dienen.

Wenn der Positionsindikator sehr große Wege zurücklegt, so müssen eine große Anzahl von Spannungswerten über die gesamte Sensorstrecke abgespeichert werden. Dies kann einen gewissen Nachteil darstellen. Unter Umständen können darüber hinaus Änderungen des Abstandes zwischen Positionsindikator (Magnet) und Sensorlinie zu Änderungen der Positionsspannungsverteilung führen und schließlich spielt auch die Stärke des für die Kalibrierung verwendeten Magneten eine Rolle für die Charakteristik der Spannungsverteilung.

Aufgabe der Erfindung ist es daher, das Verfahren der eingangs genannten Art so auszubilden, daß diese Schwierigkeiten vermieden werden und eine eindeutige Charakteristik der Positionsspannungsverteilung erhalten wird.

Gelöst wird diese Aufgabe durch die in dem Ansprüchen angegebenen erfindungsgemäßen Kalibrierungsverfahren. Die Erfindung soll nachfolgend unter Bezug auf die Diagramme erläutert werden.

Die Sensorcharakteristik, dargestellt als Spannung in Abhängigkeit von der Magnetposition in Relation zum Sensor, hat den in Bild 3 dargestellten typischen Verlauf. Steht der Magnet bei vorausgesetzter, gleichmäßiger Magnetfeldverteilung mittig über dem Sensor, gibt dieser einen charakteristischen Spannungswert ab, der hier durch entsprechende Spannungsvoreinstellung den Wert 0 erhalten soll. Nähert sich einer der Pole des Magneten dieser Sensorposition, gibt es einen zunächst linearen Anstieg bzw. Abfall der Spannung. Je nach Stärke des Magnetfeldes und Abstand des Magnetfeldes von Sensor geht dieser lineare Verlauf in einen alinearen Verlauf über, bis die maximale Ausgangsspannung infolge des Magnetfeldeinflusses erreicht ist.

Für has hier beschriebene Verfahren werden vier charakteristische Eigenschaften der Wirkung von Magnet auf magnetfeldempfindlichen Sensoren ausgenutzt:

1. Der Sensorausgangswert mit der Spannung 0 definiert eine ganz bestimmte Position des Magneten.

2. In bestimmten Grenzen der Längsverschiebung des Magneten ist die Sensorkennlinie als linear anzusetzen.

3. Bei paralleler Abstandsveränderung des Magneten zu einem Sensor ändert sich im linearen Bereich der Sensoren ausschließlich die Steigung der Kennlinie.

4. Bei genügend langen Magneten im Verhältnis zum durchschnittlichen Abstand der Sensoren können benachbarte Sensoren mit ihren Spannungswerten jeweils im linearen Bereich der Kennlinie gehalten werden.

Zur Kalibrierung des Meßsystems und zur genauen Feststellung von Längenpositionen von Magneten wird daher folgendermaßen verfahren:

Ein Magnet wird mittels einer geeigneten, mechanischen Apparatur parallel zur Linie der magnetfeldempfindlichen Sensoren in bestimmten, vorgegebenen Schrittweiten bewegt. Jedem Sensor wird mit diesem Verfahren der Längenwert zugeordnet, der einem Ausgangssignal des Sensors mit dem Wert 0 oder einem anderen charakteristischen Wert entspricht. Weiter werden Spannungen von benachbarten Sensoren zueinander in Verhältnis gesetzt und bei Erreichen bestimmter Spannungsverhältnisse werden diesem Längeneinheiten zugeordnet. Somit sind Magnetpositionen über Verhältnisse von Spannungswerten Längeneinheiten zugeordnet. Bei der Bestimmung einer unbekannten Position eines Magneten werden die entsprechenden Spannungen der einzelnen vom Magneten beeinflußten Sensoren gemessen und das Verhältnis benachbarter Gebersignale gebildet, wobei die Sensoren ausgewählt werden, deren Spannungswerte jeweils durch einen Vorzeichenwechsel gekennzeichnet sind. Einem Spannungsverhältnis von Sensoren, welchem genau ein Spannungsverhältnis des Kalibrierungsverfahrens entspricht, kommt eine bestimmte Position zu. Einem Spannungsverhältnis, welches zwischen diesen Kalibrierwerten liegt, kann mittels eines geeigneten Interpolationsverfahrens eine bestimmte Magnetposition zugeordnet werden.

Dieses beschriebene Verfahren kann abgewandelt werden, indem jeweils zu einer konstanten Schrittweite der Positionsverschiebung des Magneten bestimmte Spannungsverhältnisse abgespeichert werden, womit nicht wie vorstehend bei konstanten Spannungsverhältnissen Längeneinheiten abzuspeichern sind, sondern bei bestimmten Längeneinheiten gefundene Spannungsverhältnisse abzuspeichern wären. Bei diesem Verfahren ergäbe sich der Vorteil, daß für eine bestimmte Schrittweite des Kalibriersystems ein beliebig genaues Zahlenverhältnis der Spannungswerte ermittelbar ist.

Einsatzweise des zuvor beschriebenen Verfahrens:

Ein Stabmagnet wird fest mit einem Längensystem verbunden und schrittweise in vorgegebenen, genau meßbaren Längeneinheiten parallel zur Sensorlinie verfahren. Ergeben sich für einen Sensor Ausgangsspannungen mit dem Wert 0, während benachbarte Sensoren Plus- bzw. Minusabweichungen liefern, so wird diesem Sensor ein Positionswert in Längeneinheiten zugeordnet und abgespeichert. Dies geschieht für alle Sensoren, über denen der verschiebbare Magnet mittig positionierbar ist. Ferner wird während der Positionsverschiebung des Magneten bestimmt, wann benachbarte Sensorspannungswerte genau vorgegebene Verhältnisse erzielen. Für diese Spannungsverhältnisse wird der Wert des Längensystems für den Magneten ebenfalls abgespeichert. Dieses Verfahren ist in Bild 4 verdeutlicht. Derart werden Positionen zwischen den Sensoren bestimmt, bei denen ein fiktiv sitzender Sensor das Ausgangssignal 0 hätte. Eine weitere Darstellung ist in Bild 5 gewählt. Das Verhältnis der Spannungswerte der benachbarten Sensoren a, b entspricht genau einem Verhältnis aus dem Kalibrierlauf. Damit wird die virtuelle Kennlinie dieses fiktiven Sensors an dieser Stelle genau durch die Kalibrierposition des Magneten verlaufen. In Bild 6 ist dargestellt, wie die Verhältnisse sich darstellen, wenn die Spannungsverhältnisse zweier benachbarter Sensoren a, b nicht einem Kalibrierverhältnis entsprechen. In diesem Falle ist die unbekannte Position PX des Magneten durch Interpolation aus dem benachbarten Signalverhältnis zu gewinnen. Als benachbartes Signalverhältnis kann die Kalibrierposition aus Bild 5 verwendet werden. Es kann jedoch auch eine linksseitige Kalibrierposition verwendet werden, wie es in Bild 6 angedeutet ist.

Mit der Abspeicherung von Spannungsverhältnissen, welche zu vorgegebenen Magnetpositionen zuzuordnen sind bzw. von Magnetpositionen, welche vergegebenen Spannungsverhältnissen entsprechen, läßt sich ein System aufbauen, welches zur Positionsbestimmung von längsverschiebbaren Magneten benutzt werden kann. Magnete, welche in beliebiger Position zu Sensorreihe gebracht werden, wirken auf magnetempfindliche Sensoren, welche gemäß der DE—A—32 44 891 in ihren Spannungswerten abgefragt werden. Es werden erfindungsgemäß nun aber solche Signalwerte von Sensoren zur genauen Positionsbestimmung herangezogen, die einem Vorzeichenwechsel unterliegen. Die Verhältnisse von Spannungswerten der Sensoren werden bestimmt und hieraus wird mittels geeigneter Interpolationsverfahren die genaue Position des Magneten bestimmt.

Beschreibung zu den Zeichnungen:

Bild 1 und Bild 2 stellen unterschiedliche Positionsspannungsverteilungen für eine Magnetpositionsverschiebung dar. Der Magnet ist schematisch als Stabmagnet mit der Kennzeichnung für Nord- und Südpol dargestellt. Die Verschiebung ist gestrichelt eingezeichnet. Die Sensoren wurden mit S1—S8 ebenfalls schematisch dargestellt und in Relation zum Stabmagneten positioniert. Für die beiden Positionen des Magneten ist eine Positionsspannungsverteilung 1 in Bild 1 und eine Positionsspannungsverteilung 2 in Bild 2 dargestellt. Zu den Positionen der einzelnen Sensoren ist die jeweilige Spannung mit US1—US6 bzw. mit US2—US7 angegeben. Den einzelnen magnetfeldempfindlichen Sensoren sind entsprechende Spannungswerte mit US1—US6 in Bild 1 und mit US2—US7 in Bild 2 zugeordnet. Dem Südpol wurden positive Spannungswerte, dem Nordpol negative Spannungswerte zugeordnet.

In Bild 3 ist die Charakteristik eines Sensors beispielsweise des Sensors 4, dargestellt. Wird dem Sensor S4 der Nordpol angenähert, so wird der Spannungswert des Sensors aus der 0-Position heraus negativer werden, entsprechend positiver bei Annäherung des Südpols. In der Nähe der 0-Position des Sensors kann mit linearem Kurvenverlauf gerechnet werden.

In Bild 4 sind zwei Kennlinien für benachbarte Sensoren n und n+1 dargestellt. Geben die Sensoren jeweils Spannungssignale mit dem Spannungsausgangswert 0 ab, erhalten die Sensoren den Positionswert Pn bzw. Pn+1. Wird der Magnet zwischen den beiden Sensoren verschoben, stellen sich an den Sensoren bestimmte Spannungsverhältnisse ein, die in Bild 4 mit entsprechenden Brüchen dargestellt sind. Bei Erreichen bestimmter Zahlenverhältnisse der Spannungssignale werden entsprechende Positionswerte, bezeichnet mit Pna—Pnc, abgelegt. Ergeben die Sensoren bei späteren Messungen diese Signalverhältnisse, so können daraus die entsprechenden Positionen, wie in Bild 4 dargestellt, ermittelt werden.

Bild 5 zeigt, wie die Verhältnisse sich darstellen, wenn das Spannungsverhältnis a, b genau einem Kalibrierungsverhältnis entspricht, so daß sich die Kalibrierposition Pc ergibt. Durch diesen Punkt Pc kann die virtuelle Kennlinie eines fiktiven Sensors gezogen werden, der genau in dieser Position den Spannungswert 0 liefert.

In Bild 6 ist dargestellt, wie Spannungsverhältnisse a, b vorliegen, die nicht einem Kalibrierpunkt Pc entsprechen. In diesem Falle handelt es sich um Spannungsverhältnisse, die dem unbekannten Positionswert Px des Magneten entsprechen. Eine solche Position Px ist durch eine rechtsseitige Kalibrierposition bzw. durch eine linksseitige Kalibrierposition eingeschlossen. Aus den Spannungsverhältnissen für diese rechts- bzw. linksseitige Kalibrierposition kann der Wert Px per Interpolationsverfahren ermittelt werden.

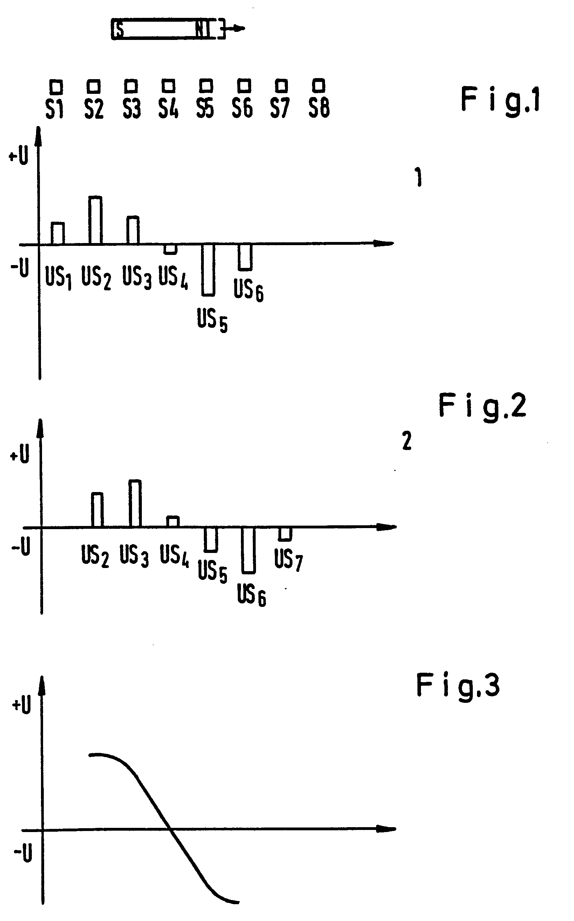

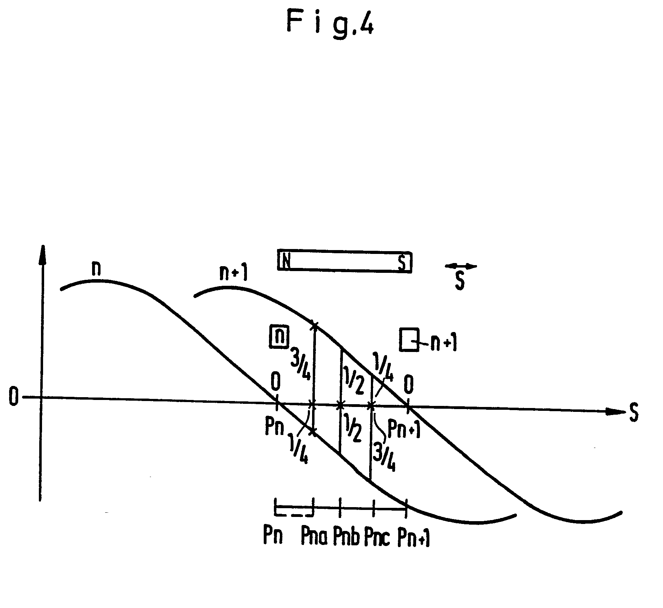

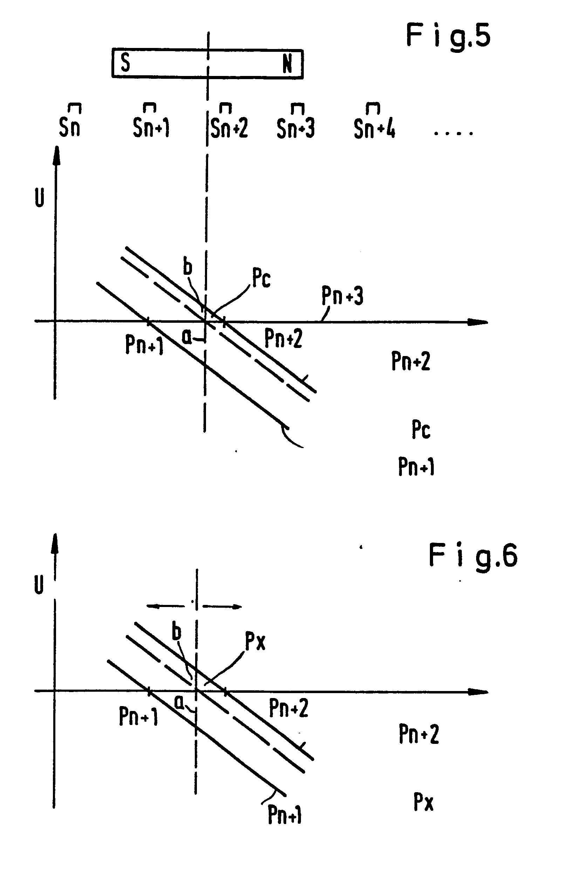

## Patentansprüche

1. Verfahren zur Kalibrierung einer Einrichtung zur berührungslosen Positionsmessung, bei der ein bewegbares, der Positionsbestimmung unterworfenes Teil vorgesehen ist, dem ein Sensorträger räumlich benachbart zugeordnet ist, der eine Mehrzahl von elektrisch und räumlich voneinander getrennten Sensoren aufweist, von denen jeder an Spannung legbar ist und bei der eine Abfrage- und Auswerteinrichtung vorgesehen ist, mit der die Einzelsensoren zwecks Feststellung ihres von der Position des bewegbaren Teils abhängigen Ausgangssignales verbindbar sind, wobei des bewegbare Teil als einen Verbraucher darstellender oder Feldlinien aussendender Positionsindikator ausgebildet ist und wobei die bei dessen Positionsänderung erzeugten oder gewandelten Spannungssignale eine Information enthalten, die ausgewertet wird, wobei ferner die Sensoren in definiertem Abstand auf dem Träger angeordnet sind un in ihrer Position für die Auswertung zur Verfügung stehen und die Abfrage- und Auswerteinrichtung mit jedem der Sensoren zwecks Feststellung seines von der Position und seiner geometrischen und physikalischen Ausgestaltung des ortsveränderlichen oder ruhenden Positionsindikators abhängigen Ausgangssignals verbunden ist, wobei außerdem ein elektronischer Multiplexer vorgesehen ist, an den die einzelnen Sensoren zwecks getrennter überleitung ihrer Ausgangssignale an die Auswerteinrichtung anschließbar sind und wobei die elektronische Auswerteinrichtung einen charakteristischen Punkt der Signale als Position für die Stellung des Positionsindikators nimmt und somit auch Positionsbestimmungen zwischen den einzelnen Sensoren auslöst, dadurch gekennzeichnet, daß der Positionsindikator parallel zur Linie der Sensoren bewegt wird und jedem Sensor jeweils dann ein Längenwert zugeordnet wird, wenn das Ausgangssignal eines Sensors den Spannungswert Null zeigt und diesem Sensor benachbarte Sensoren auf der einen Seite des den Wert Null aufweisenden Sensors Plusabweichungen und auf der anderen Seite dieses Sensors Minusabweichungen im Spannungswert aufweisen und daß während der Positionsverschiebung des Positionsindikators dann weitere Längenwerte abgespeichert werden, wenn benachbarte Spannungswerte der Sensoren genau definierte Verhältnisse zeigen.

2. Verfahren zur Kalibrierung einer Einrichtung zur berührungslosen Positionsmessung, bei der ein bewegbares, der Positionsbestimmung unterworfenes Teil vorgesehen ist, dem ein Sensorträger räumlich benachbart zugeordnet ist, der eine Mehrzahl von elektrisch und räumlich voneinander getrennten Sensoren aufweist, von denen jeder an Spannung legbar ist und bei der eine Abfrage- und Auswerteinrichtung vorgesehen ist, mit der die Einzelsensoren zwecks Feststellung ihres von der Position des bewegbaren Teils abhängigen Ausgangssignales verbindbar sind, wobei das bewegbare Teil als einen Verbraucher darstellender oder Feldlinien aussendender Positionsindikator ausgebildet ist und wobei die bei dessen Positionsänderung erzeugten oder gewandelten Spannungssignale eine Information enthalten, die ausgewertet wird, wobei ferner die Sensoren in definiertem Abstand auf dem Träger angeordnet sind un in ihrer Position für die Auswertung zur Verfügung stehen und die Abfrage- und Auswerteinrichtung mit jedem der Sensoren zwecks Feststellung seines von der Position und seiner geometrischen und physikalischen Ausgestaltung des ortsveränderlichen oder ruhenden Positionsindikators abhängigen Ausgangssignals verbunden ist, wobei außerdem ein elektronischer Multiplexer vorgesehen ist, an den die einzelnen Sensoren zwecks getrennter überleitung ihrer Ausgangssignale an die Auswerteinrichtung anschließbar sind und wobei die elektronische Auswerteinrichtung einen charakteristischen Punkt der Signale als Position für die Stellung des Positionsindikators nimmt und somit auch Positionsbestimmungen zwischen den einzelnen Sensoren auslöst, dadurch gekennzeichnet, daß der Positionsindikator parallel zur Linie der Sensoren mit · konstanten Schrittweiten bewegt wird und die bei dieser konstanten Postionsverschiebung auftretenden Spannungsverhältnisse abgespeichert werden, die von Spannungswerten diesem Positionsindikator benachbarter Sensoren abgeleitet werden.

## Revendications

1. Procédé pour calibrer un dispositif servant à exécuter une mesure de position sans contact et dans lequel il est prévu une partie mobile, soumise à la détermination de position, à laquelle est associé un porte-capteurs, qui en est voisin dans l'espace et possède une multiplicité de capteurs séparés les uns des autres du point de vue électrique et spatial et pouvant être raccordés chacun à une tension, et dans lequel il est prévu un dispositif d'interrogation et d'évaluation auquel les capteurs individuels peuvent être reliés en vue de la détermination de leur signal de sortie qui dépend de la position de la partie mobile, et dans lequel la partie mobile est agencée sous le forme d'un indicateur de position représentant l'appareil d'utilisation ou émettant des lignes de champ et les signaux de tension produits ou convertis lors de la variation de l'indication de position de cet indicateur contiennent une information que l'on évalue, et en outre les capteurs sont disposés à une distance définie sur le support et sont disponibles, dans leur position, pour l'évaluation, et le dispositif d'interrogation et d'évaluation est relié à chacun des capteurs en vue de la détermination du signal de sortie de chaque capteur, qui dépend de la position et de l'agencement géométrique et physique de l'indicateur de position qui est variable dans l'espace ou est à l'arrêt, et en outre il est prévu un multiplexeur électronique, auquel les différents capteurs peuvent être raccordés en vue de la retransmission séparée de leurs signaux au dispositif d'évaluation, et le dispositif d'évaluation électronique utilise un point caractéristique des signaux en tant que position indicative de la position de l'indicateur de position et déclenche par conséquent également des déterminations de position entre les différents capteurs, caractérisé en ce qu'on déplace l'indicateur de position parallèment à la ligne des capteurs et qu'a chaque capteur est alors associé respectivement une valeur de longueur lorsque le signal de sortie d'un capteur fournit la valeur de tension nulle, et que la valeur de tension appliquée à des capteurs voisins de ce capteur présente des écarts positifs, d'un côté du capteur indiquant la valeur zéro, et des écarts négatifs de l'autre côté de ce capteur, et que pendant le décalage de la position de l'indicateur de position, d'autres valeurs de longueurs sont mémorisées lorsque des valeurs de tension voisines des capteurs présentent des conditions définies de façon précise.

2. Procédé pour calibrer un dispositif servant à exécuter une mesure de position sans contact et dans lequel il est prévu une partie mobile, soumise à la détermination de position, à laquelle est associé un porte-capteurs, qui en est voisin dans l'espace et possède une multiplicité de capteurs séparés les uns des autres du point de vue électrique et spatial et pouvant être raccordés chacun à une tension, et dans lequel il est prévu un dispositif d'interrogation et d'évaluation auquel les capteurs individuels peuvent être reliés en vue de la détermination de leur signal de sortie qui dépend de la position de la partie mobile, et dans lequel la partie mobile est agencée sous la forme d'un indicateur de position représentant l'appareil d'utilisation ou émettant des lignes de champ et les signaux de tension produits ou convertis lors de la variation de l'indication de position de cet indicateur contiennent une information que l'on évalue, et en outre les capteurs sont disposés à une distance définie sur le support et sont disponibles, dans leur position, pour l'évaluation, et le dispositif d'interrogation et d'évaluation est relié à chacun des capteurs en vue de la détermination du signal de sortie de chaque capteur, qui dépend de la position et de l'agencement géométrique et physique de l'indicateur de position qui est variable dans l'espace ou est à l'arrêt, et en outre il est prévu un multiplexeur électronique, auquel les différents capteurs peuvent être raccordés en vue de la retransmission séparée de leurs signaux au dispositif d'évaluation, et le dispositif d'évaluation électronique utilise un point caractéristique des signaux en tant que position indicative de la position de l'indicateur de position et déclenche par conséquent également des déterminations de position entre les différents capteurs, caractérisé en ce qu'on déplace l'indicateur de position parallèlement à la ligne des capteurs, avec des longueurs de pas constantes et on mémorise les rapports de tension, qui apparaissent lors de ce déplacement constant de position et sont dérivés de valeurs de tension de capteurs voisins de cet indicateur de position.

## Claims

1. A method for calibrating a device for noncontact position measurement wherein a movable part subject to positional identification is provided spatially proximate to a sensor carrier that includes a plurality of sensor electrically and spatially separated from one another, of which each one can be laid to voltage and for which an interrogation and evaluation device is intended, with which the individual sensors are connectable for the purpose of identification of its output signal dependent of the position of the moving part, at which the moving part is developed a consumer of representative or field lines emitting position indicator and at which the voltage signals generated or changed at its position change embody an information, which is evaluated, at which further the sensors are arranged in defined spacing on the carrier and are available in their position for the evaluation and the interrogation and evaluation device is connected with each sensor for the purpose of identification of its output signal which is dependent on its position and its geometric and physical position of the movable or non-operative position indicator, at which besides an electronic multiplexer is assigned at which each sensor is connectable for the purpose of the divided connection of their output signals to the evaluation device and at which the electronic evaluation device uses a characteristic point of the signals as position for the position of the position indicator and thus starts also the positional identification between the individual sensors, identified thereby that the position indicator is moved parallel to the sensor line and for each sensor respectively one length value is then assigned, when the output signal of a sensor shows the voltage value zero and the neighboring sensor to this sensor on one side of the sensor showing zero shows positive differences and on the other side of this sensor shows negative differences in the voltage value and that during the positional dislocation of the position indicator further length values are then stored, when neighboring voltage values of sensors show exactly defined relationship.

2. A method for calibrating a device for noncontact position measurement wherin a movable part subject to a positional identification is provided spatially proximate to a sensor carrier that includes a plurality of sensor electrically and spatially separated from one another, of which each one can be laid to voltage and for which an interrogation and evaluation device is intended, with which the individual sensors are connectable for the purpose of identification of its output signal dependent of the position of the moving part, at which the moving part is developed a consumer of representative or field lines emitting position indicator and at which the voltage signals generated or changed at its position change embody an information, which is evaluated, at which further the sensors are arranged in defined spacing on the carrier and are available in their position for the evaluation and the interrogation and evaluation device is connected with each sensor for the purpose of identification of its output signal which is dependent on its position and its geometric and physical position of the movable or non-operative position indicator, at which besides an electronic multiplexer is assigned at which each sensor is connectable for the purpose of the divided connection of their output signals to the evaluation device and at which the electronic evaluation device uses a characteristic point of the signals as position for the position of the position indicator and thus starts also the positional identification between the individual sensors, identified thereby that the position indicator is moved parallel to the line of sensors with constant step distance and the voltage relationships which occur at this constant positional dislocation are stored, which are derived of the voltage values of neighboring sensors to this position indicator.

Fig.1

Fig.2

Fig.3

# Fig.4

Fig.5

S    N

Sn    Sn+1    Sn+2    Sn+3    Sn+4    ....

U

b

Pc

Pn+3

Pn+1    a    Pn+2

Pn+2

Pc

Pn+1

Fig.6

U

b    Px

Pn+1    a    Pn+2

Pn+2

Pn+1

Px